# EUROPÄISCHE PATENTSCHRIFT

(11) **EP 3 368 864 B1**
(45) Veröffentlichungstag und Bekanntmachung des Hinweises auf die Patenterteilung: **04.03.2020**
(21) Anmeldenummer: 16787722.4
(22) Anmeldetag: 28.09.2016
(51) Int. Cl.: G01D 11/24, G01D 5/14, F16C 41/00, G01P 1/02, G01D 5/251, G01D 5/252, H05K 7/02

(54) **LAGERANORDNUNG MIT DARIN EINGEBAUTER ELEKTRISCHER LEITUNG ZUR BEREITSTELLUNG VON MEHREREN BETRIEBSSPANNUNGEN**
BEARING ASSEMBLY WITH INCORPORATED ELECTRIC LINE FOR PROVIDING MULTIPLE OPERATING VOLTAGES
ENSEMBLE DE PALIER DANS LEQUEL EST INTÉGRÉ UN CONDUCTEUR ÉLECTRIQUE POUR LA PRODUCTION DE PLUSIEURS TENSIONS DE SERVICE

(30) Priorität: 27.10.2015 DE 102015220921
(43) Veröffentlichungstag der Anmeldung: 05.09.2018
(73) Patentinhaber: Schaeffler Technologies AG & Co. KG, 91074 Herzogenaurach (DE)
(72) Erfinder: WEETH, Christoph, 97440 Werneck (DE); HEIM, Jens, 97493 Bergrheinfeld (DE)
(86) Internationale Anmeldenummer: PCT/DE2016/200454
(87) Internationale Veröffentlichungsnummer: WO 2017/071702

(56) Entgegenhaltungen:
- EP-A1- 2 508 859
- EP-A2- 0 432 122
- EP-A2- 1 717 464
- WO-A1-2005/081268
- WO-A1-2015/156070
- WO-A2-01/77634
- DE-U1- 20 005 520
- FR-A1- 2 081 892
- JP-A- 2009 025 009
- US-A1- 2003 196 828

## Beschreibung

Die vorliegende Erfindung betrifft eine Lageranordnung mit einem Lager zur Lagerung eines Maschinenteils, einem Bauraum innerhalb der Lageranordnung zur Aufnahme eines oder mehrerer Elektronikmodule sowie einem sich im Bauraum erstreckenden Träger mit Leiterbahnen, die der elektrischen Versorgung bzw. Kopplung dieser Elektronikmodule dienen. Bevorzugt befindet sich der Bauraum im Lager, jedoch kann er auch an der Außenseite des Lagers vorgesehen sein.

Beispielsweise kann das Lager ein Wälzlager sein, weiches zwei zueinander rotierbare Bauteile, d.h. Innen- und Außenring, sowie mehrere Wälzkörper umfasst. Beispielsweise zur Lastmessung sind in solchen Lagern Messdatenerfassungssysteme in Form von Elektronikmodulen integriert. Die Elektronikmodule können z.B. Sensoren, Patenverarbeitungseinheiten und Schnittstellen zur Ausgabe von Daten umfassen. Ebenso können Stromversorgungseinheiten in die Elektronikmodule integriert sein.

In den Patentdokumenten WO 2013/005068 A1, WO 2007/104894 A1, EP 2 682 758 A1 sind Anordnungen von Elektronikmodulen zur Winkelmessung in Lagerreihen dargestellt. In der WO 2007/104894 A1 wird weiterhin beschrieben, dass eine Elektronikplatine an einem Flansch befestigt wird.

In der WO 2010/070392 A1 wird ein Wälzlager mit einstellbarer Distanz der Elektronikmodule zum rotierenden Teil des Lagers sowie der Herstellungsprozess des Wälzlagers mit Elektronikmodulen beschrieben.

In der JP 2004/251316 A wird eine Befestigung der Elektronik am Außenring eines Lagers durch einen Pressverbund des Gestänges mit dem Außenring und zusätzliches Laser- bzw. Elektronenstrahlschweißen erläutert.

Die WO 2010/143022 offenbart eine Wälzlageranordnung mit Elektronikmodulen zur Messung von Rotationsparametern. Ähnliches wird in der WO 2012/080780 gezeigt. Aus der EP 1 933 155 A1 ist ein Wälzlager mit einer Einrichtung zur Bestimmung von Rotationsparametern sowie einer flexiblen faltbaren nicht rotierenden Elektronikplatine mit Elektronikmodulen bekannt. Es werden verschiedene Ausführungsformen der Platinen bzw. Leiterplatten beschrieben. In einer ersten Ausführungsform hat die Platine die Form einer Scheibe. Eine zweite Ausführungsform ist durch eine biegsame Platine gebildet, die in Umlaufrichtung des Lagers angeordnet ist. Dabei sind sowohl gebogene als auch gerade Abschnitte auf der Platine vorgesehen. Elektronikmodule sind in festgelegten Abständen auf den geraden Abschnitten befestigt. Die Platine wird an einem Träger im Lager gebondet oder beispielsweise durch einen Clip in Position gehalten.

Aus der DE 200 05 520 U1 ist eine Vorrichtung zum Leiten von elektrischem Strom bekannt. Die Vorrichtung umfasst mindestens zwei elektrische Leiter, welche zumindest in einem Teilbereich nicht parallel zueinander verlaufen. Weiterhin umfasst die Vorrichtung eine Isolationseinrichtung.

Die US 2003/196828 A1 beschreibt ein flaches elektrisches Kabel, welches aus einer oberen und einer unteren Isolatorschicht besteht, wobei die beiden Isolationsschichten miteinander in Verbindung stehen. Zwischen den beiden Schichten sind elektrische Leiter angeordnet.

In der WO 2005/081268 A1 ist eine Leiterplatte beschrieben. Aus parallel angeordneten Leitern und einem auf den Leitern aufgebrachten und belichteten fotosensitiven Mittel eines Isolators wird ein Verdrahtungsmuster gebildet. Weiterhin weist die Leiterplatte und damit das Verdrahtungsmuster Öffnungen für externe Verbindungen auf.

Der FR 2 081 892 A1 ist ein flexibles elektrisches Flachkabel zu entnehmen. Das Flachkabel umfasst einen durchgängigen streifenförmigen Träger. Weiterhin umfasst das Flachkabel eine Mehrzahl an Leitern, welche auf dem Träger angeordnet sind, sowie eine die Leiter abdeckende Isolationsschicht. Die Isolationsschicht weist in regelmäßigen Abständen Öffnungen auf. Durch die Öffnungen kann ein Anschluss der Leiter an äußere elektrische Schaltkreise erfolgen.

In der EP 0 432 122 A2 wird eine Nabeneinheit beschrieben, welche aus einem ersten rotierbaren und einem zweiten nicht rotierbaren Lagerring besteht. Weiterhin umfasst die Nabeneinheit eine in sich geschlossene, nicht rotierbare Messeinheit zum Messen einer externen Kraft, wobei die Messeinheit fest an dem zweiten Lagerring angeordnet ist. Die Einheit umfasst mehrere Messeinheiten und einen ringförmigen Träger auf dem die Messeinheiten angeordnet sind. Jede Messeinheit weist eine Vielzahl an Sensoren, insbesondere Kraftmesssensoren auf. Jeder Messkörper ist von einer Aufnahmespule umgeben. Um die Außenseite der Messkörper ist eine Erregerspule gewickelt, welche an einer Stromquelle angeschlossen werden kann, wobei die Erregerspule die Flächen und die Aufnahmespulen umgibt.

Die JP 2009 025009 A zeigt eine Wälzlagereinheit und eine Mengenmessvorrichtung für diese. Die Vorrichtung umfasst einen Sensorhalter, welcher an einer Abdeckung angeordnet ist. Auf dem Sensorhalter sind Sensormodule mit Sensoren sowie eine Sammelschiene angeordnet. Im Einbauszustand erstrecken sich die Sensoren in Durchgangslöcher, welche in der Abdeckung ausgebildet sind.

In einer früheren deutschen Patentanmeldung der Anmelderin mit der Anmeldenummer 10 2015 202 129.7 ist eine Elektronikmodulanordnung beschrieben die in einem zylindrischen Bauraum eines Lagers angeordnet ist. Die Anordnung besteht aus einem Träger, einer elektrischen Leitung und ein oder mehreren Elektronikmodulen welche elektrisch mit der Leitung verbunden sind. Weiterhin ist dort offenbart, dass die Anordnung an den jeweiligen zylindrischen Bauraum angepasst werden kann, wodurch keine speziell definierten für den jeweiligen Durchmesser passenden Elektronikkomponenten entwickelt und eingebaut werden müssen. Der Inhalt dieser früheren Anmeldung wird in den Offenbarungsgehalt der vorliegenden Patentanmeldung ausdrücklich einbezogen, insbesondere in Bezug auf die spezifische Konstruktion des Trägers mit der Leitung und die Möglichkeit der Positionierung der Elektronikmodule.

Es ist üblich in derartigen Lageranordnungen aus Kostengründen nur Elektronikmodule zu verwenden die mit derselben Systemversorgungsspannung arbeiten. Sollen in einer Lageranordnung Elektronikmodule mit unterschiedlichen Versorgungspannungen zum Einsatz kommen, muss jedes Funktionsmodul zunächst durch ein Energieversorgungsmodul mit der entsprechenden Spannung versorgt werden, wobei für jede Spannung eine eigene elektrische Leiterbahn auf dem Träger benötigt wird, wodurch viel Platz auf dem Träger benötigt wird. Dasselbe gilt für die Signalübertragung über die Leiterbahnen auf dem Träger, insbesondere wenn als Elektronikmodul Schnittstellenmodule zur Umwandlung der Signale verwendet werden. Da der Bauraum im oder am Lager begrenzt ist, lassen sich nicht beliebig viele Leiterbahnen auf dem Träger unterbringen, sodass bestimmte Schaltungsanordnungen nicht mehr realisierbar sind, wenn mehrere Versorgungsspannungen benötigt werden oder Signale zwischen einzelnen Elektronikmodulen zu übertragen sind.

Die Aufgabe der vorliegenden Erfindung besteht somit darin, eine Lageranordnung mit einer elektrischen Leitung, die an verschiedene Bauraumgrößen bzw. Trägergrößen angepasst werden kann, zur Verfügung zu stellen, die es gleichzeitig gestattet, unterschiedliche Spannungen oder Signale an die Elektronikmodule bereit zu stellen, ohne dass dafür mehr Platz auf dem Träger für zusätzliche Leiterbahnen benötigt wird.

Erfindungsgemäß erfolgt die Lösung der Aufgabe durch eine Lageranordnung gemäß dem beigefügten Anspruch 1.

Die erfindungsgemäße Lageranordnung umfasst ein Lager, welches zur Lagerung eines Maschinenteils dient, und einen innerhalb der Lageranordnung befindlichen Bauraum zur Aufnahme von mindestens einem, vorzugsweise mehreren Elektronikmodulen, Weiterhin umfasst die Lageranordnung einen im Bauraum positionierten Träger in dessen Längsrichtung eine elektrische Leitung verläuft. Auf der elektrischen Leitung befinden sich mindestens eine durchgehende elektrische Leiterbahn und mindestens eine unterbrochene elektrische Leiterbahn mit mindestens einer Unterbrechung, wobei die unterbrochene Leiterbahn sowohl vor wie auch nach der Unterbrechung parallel zur durchgehenden Leiterbahn verläuft. Auf dem Träger ist mindestens ein Elektronikmodul befestigt, welches mit einer oder mehreren der Leiterbahnen kontaktiert ist.

Das Lager ist vorzugsweise ein Wälzlager. Vorzugsweise sind der Träger und die elektrische Leitung an den Durchmesser des jeweiligen zylindrischen Bauraums angepasst. Das bedeutet der Träger ist ein hohlzylindrisches Gebilde und die elektrische Leitung wird als eine flexible elektrische Leitung ausgeführt und in der

Umfangsrichtung des Trägers ringförmig zumindest teilweise angeordnet. Die elektrische Leitung ist aus mehreren Schichten aufgebaut, die zur Realisierung der Flexibilität aus Folien bestehen.

Vorzugsweise wird eine einfache Anpassung an unterschiedliche Bauraumdurchmesser ermöglicht. Hierzu ist lediglich eine Anpassung des Trägers an den jeweiligen Bauraum erforderlich. Die werthaltigen und entwicklungsaufwendigen Elektronikmodule bleiben dagegen in ihrer Geometrie, Kontaktierung und Funktionalität unverändert, wodurch sie in zahlreichen Produktvarianten Verwendung finden können. Erfindungsgemäß kann damit ein modulares System für vielfältige Einsatzzwecke zur Verfügung gestellt werden. So können an die üblicherweise vorliegenden Bauräume angepasste Träger mit verschiedenen Durchmessern vorgehalten werden, welche bedarfsweise mit gleichartigen, mittels des elektrischen Leiters verbundenen Elektronikmodulen kombiniert werden können.

Ein Vorteil des Einsatzes einer flexiblen elektrischen Leitung ist, dass diese einfach zu kürzen ist und somit an den jeweiligen Träger und dessen Lager bedingte Krümmung angepasst werden kann.
Mit der elektrischen Leitung sind die Elektronikmodule elektrisch, vorzugsweise auch mechanisch verbunden. Die Elektronikmodule sind vorzugsweise Energieversorgungsmodule, Funktionsmodule, Schutzbeschaltungsmodule und/oder Schnittstellentwandlermodule. Sie besitzen an mindestens einer Seite mindestens eine elektrische Kontaktstelle, die vorzugsweise aus einem elektrisch leitenden Werkstoff besteht. Nach einer vorteilhaften Ausführungsform sind die Elektronikmodule und deren Kontaktstellen quaderförmig ausgebildet.
Über ein Verbindungselement aus einem elektrisch leitenden Werkstoff sind die elektrischen Kontaktstellen der Elektronikmodule mit elektrischen Kontaktstellen der elektrischen Leitung elektrisch verbunden. Das Verbindungselement wird vorzugsweise als metallische Legierung (Silber-Zinn-Lot), Komposit in einer organischen Matrix (Leitkleber) oder als Einzelmetall (Bonddraht) realisiert.

Die elektrische Leitung weist mehrere übereinander gestapelte elektrisch leitende Schichten, die elektrischen Leiterbahnen, und elektrisch nicht leitende Schichten auf. Die Schichten sind zweckmäßigerweise mittels Folien realisiert. Sie besitzen bevorzugt eine Dicke < 500 µm, wobei bedarfsweise auch andere Schichtdicken möglich sind.

Als günstig hat es sich erwiesen, die Elektronikmodule mittels einer adhäsiven Schicht an der elektrischen Leitung zu befestigen. Die adhäsive Schicht auf der elektrischen Leitung wird vorzugsweise über einen geeigneten Klebstoff realisiert.

Die flexible elektrische Leitung weißt erfindungsgemäß mindestens zwei elektrische Leiterbahnen auf, nämlich eine durchgehende elektrische Leiterbahn und eine unterbrochene elektrische Leiterbahn mit mindestens einer Unterbrechung.
Ein Elektronikmodul befindet sich an der Position der Unterbrechung der Leiterbahn und überdeckt diese in mechanischer Hinsicht. Das Elektronikmodul wandelt ein an seiner eingangsseitigen ersten elektrischen Kontaktstelle anliegendes Eingangssignal in ein zu diesem verschiedenes Ausgangssignal und stellt dieses an seiner ausgangsseitigen zweiten Kontaktstelle bereit. Die erste Kontaktstelle ist mit der unterbrochenen Leiterbahn vor der Unterbrechung elektrisch verbunden, während die zweite Kontaktstelle mit der unterbrochenen elektrischen Leiterbahn nach der Unterbrechung verbunden ist. Durch die Unterbrechung der elektrischen Leiterbahn und die Signalwandlung durch das Elektronikmodul weisen der Leiterbahnabschnitt vor sowie der Leiterbahnabschnitt nach der Unterbrechung zueinander unterschiedliche bzw. getrennte Signale auf.
In einer besonders bevorzugten Ausführungsform entspricht eine Eingangsspannung dem Eingangssignal und eine Ausgangsspannung dem Ausgangssignal. Elektronikmodule zur Signalumwandlung können beispielsweise Energieversorgungsmodule oder Schnittstellenwandlermodule sein.
In einer bevorzugten Ausführungsform ist das Elektronikmodul somit ein Energieversorgungsmodul, welches ein an seiner eingangsseitigen ersten elektrischen Kontaktstelle anliegendes Eingangspotenzial in ein zu diesem verschiedenes Ausgangspotenzial umwandelt und an seiner ausgangsseitigen zweiten Kontaktstelle bereitstellt.

In einer anderen bevorzugten Ausführungsform ist das Elektronikmodul ein Schnittstellenwandlermodul, welches ein an seiner eingangsseitigen ersten elektrischen Kontaktstelle anliegendes Eingangssignal in ein zu diesem verschiedenes Ausgangssignal umwandelt und an seiner ausgangsseitigen zweiten Kontaktstelle bereitstellt.

Werden mehrere Unterbrechungen auf der Leitung realisiert und durch Energieversorgungsmodule übergriffen, können mehrere unterschiedliche Spannungspotenziale auf der flexiblen elektrischen Leitung übertragen werden, ohne dass dafür zusätzlicher Bauraum für Leiterbahnen mit verschiedenen Spannungen notwendig wird. Demzufolge bedarf es auf dem Träger prinzipiell nur einer ggf. mehrfach unterbrochenen Leiterbahn, deren einzelne Abschnitte unterschiedliche Versorgungsspannungen führen, die von nachgeordneten Funktionsmodulen benötigt werden. Dadurch wird nicht nur Material sondern vor allem Platz auf dem Träger bzw. im Bauraum eingespart. Es ist ersichtlich, dass diese Mehrfachnutzung des Platzes auf dem Träger auch bei unterbrochenen Leiterbahnen erreicht wird, die anstelle einer Versorgungsspannung ein anderes Signal führen.

Nach dem Energieversorgungsmodul ist regelmäßig ein Funktionsmodul auf der elektrischen Leitung angeordnet, d.h. das Funktionsmodul befindet sich ausgangsseitig des Energieversorgungsmoduls und wird durch dieses entsprechend mit einer Betriebsspannung versorgt. Natürlich ist in bekannter Weise auch eine Positionierung von Funktionsmodulen vor dem Energieversorgungsmodul möglich, soweit diese vorgelagerten Module nicht die Betriebsspannung benötigen, die erst von dem Energieversorgungsmodul erzeugt wird.

Zum Einhalten der Position und der entsprechenden Abstände zwischen den auf dem Träger angeordneten Modulen befinden sich vorzugsweise Aufnahmeelemente am Träger, weiche auch die mechanische Schnittstelle bilden, Die Aufnahmeelemente bzw. Aufnahmen sind fest mit dem Träger verbunden.

Wenn die eingangsseitigen elektrischen Schnittstellen sowohl bei den Energieversorgungsmodulen, als auch bei den Funktionsmodulen in ihrer Formgebung gleich ausgeprägt sind, können die Positionen der Module auf dem Träger unter Verwendung der Aufnahmen frei gewählt werden. Daraus ergibt sich der Vorteil vieler unterschiedlicher Bestückungsvarianten. Ein weiterer Vorteil ist, dass die mechanische Befestigung der Module am Träger in gewisser Entfernung zu den elektrischen Schnittstellen realisiert werden kann und somit die Gefahr einer Beschädigung der Bauteile minimiert wird.

Die Elektronikmodule sind bevorzugt nacheinander in Umlaufrichtung des Trägers auf der flexiblen elektrischen Leitung gruppiert, das bedeutet sie sind zur Drehachse hin radial ausgereichtet, was einem sternförmigen Aufbau gleich kommt.

Eine Leiterbahn der Leitung ist bevorzugt mit der Systemeingangsspannung belegt, welche bedarfsweise von den Funktionsmodulen abgegriffen wird. Eine vorteilhafte Ausführungsform verwendet einen Träger aus Kunststoff.

Bevorzugte Ausführungsformen der Erfindung werden nachfolgend anhand der beigefügten Figuren näher erläutert. Es zeigen:
- Fig. 1: eine perspektivische Ansicht eines Ausschnitts einer erfindungsgemäßen Lageranordnung:
- Fig. 2: eine Detaildarstellung einer elektrischen Leitung mit einem kontaktierten Elektronikmodul.

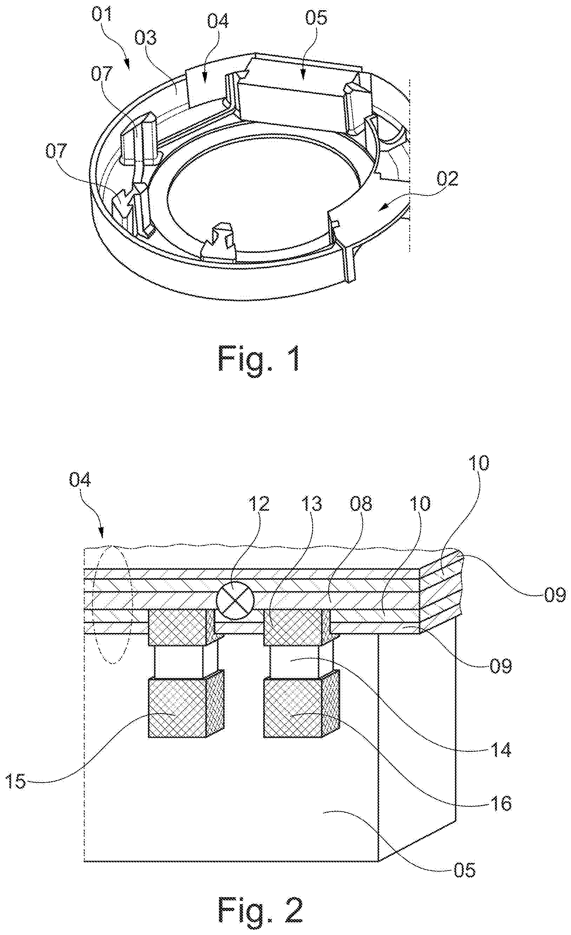

Fig. 1 zeigt eine perspektivische Ansicht eines Teils einer erfindungsgemäßen Lageranordnung 01. Die Lageranordnung 01 umfasst in an sich bekannter Weise ein Lager zur Lagerung eines Maschinenteils (nicht gezeigt), wobei im Lager auch ein Bauraum vorgesehen ist zur Aufnahme eines hohlzylindrischen Trägers 02. Der Träger 02 ist in seinen Abmessungen insbesondere hinsichtlich Innen- und Außendurchmesser an den vorzugsweise zylindrischen Bauraum im Lager angepasst. Im einfachsten Fall füllt der Träger 02 den zylindrischen Bauraum vollständig aus. Der Träger 02 besteht vorzugsweise aus Kunststoff und lässt sich beispielsweise als einstückiges Spritzgussteil fertigen. An einer Innenwand 03 des Trägers 02 ist eine elektrische Leitung 04 angeordnet, welche vorzugsweise flexibel ausgeführt ist. Die flexible elektrische Leitung 04 erstreckt sich in Umfangsrichtung zumindest über einen Teilbereich des Trägers 02, vorzugsweise am gesamten Umfang des Trägers.

Im Träger 02 sind weiterhin bevorzugt quaderförmige Elektronikmodule 05 aufgenommen, wobei in Fig. 1 zur besseren Übersichtlichkeit lediglich ein Elektronikmodul 05 dargestellt ist. Ausführungen mit mehr Elektronikmodulen 05 sind natürlich möglich. Die Elektronikmodule sind aneinandergereiht und in zueinander festgelegten Abständen im Träger angeordnet. Wenn der zur Verfügung stehende Raum im Träger voll ausgenutzt werden muss, können die Elektronikmodule an ihren vom Trägerradius ausgehenden innen liegenden Kanten aneinander anstoßen. Die Elektronikmodule sind beispielsweise Energieversorgungsmodule, Funktionsmodule, wie z.B. Sensormodule, Schutzbeschaltungsmodule und/oder Schnittstellenwandlermodule. Zur Halterung der Elektronikmodule 05 weist der Träger 02 entsprechend ausgeformte Aufnahmen 07 auf.

Die einzelnen Elektronikmodule 05 sind über die elektrische Leitung 04 elektrisch miteinander verbunden, wobei auch eine mechanische Verbindung entsteht, die aber keine tragende Funktion übernehmen muss.

Fig. 2 zeigt im Detail eine Darstellung der elektrischen Leitung 04 und des Elektronikmoduls 05 sowie deren Kontaktierung. Die flexible elektrische Leitung 04 besteht bei der dargestellten Ausführungsform aus mehreren übereinander gestapelten Schichten, von denen die elektrisch leitenden Schichten elektrische Leiterbahnen 08 bilden und die elektrisch nicht-leitenden u.a. eine Schutzschicht 09 und eine adhäsive Schicht 10 umfassen können. Die einzelnen Schichten haben vorzugsweise eine Schichtdicke < 500µm. In Fig. 2 ist lediglich eine elektrisch leitende Schicht realisiert. Ausführungen mit mehreren elektrischen Schichten sind jedoch möglich.

Die erfindungsgemäße Lageranordnung umfasst mindestens zwei elektrische Leiterbahnen als Bestandteil der elektrischen Leitung, nämlich eine durchgehende elektrische Leiterbahn und eine unterbrochene elektrische Leiterbahn mit mindestens einer Unterbrechung 12. In der in Fig. 2 gezeigten Schnittansicht ist die unterbrochene elektrische Leiterbahn 08 mit ihrer Unterbrechung 12 abgebildet. In praktischen Ausführungen werden regelmäßig mehrere durchgehende elektrische Leiterbahn sowie mindestens eine, bei Bedarf auch mehrere unterbrochene elektrische Leiterbahnen zur Anwendung kommen.

Die elektrische Leitung 04 ist mittels ihrer adhäsiven Schichten 10 mit den Elektronikmodulen 05 mechanisch verbunden. Die elektrische Leitung 04 besitzt eine vorgegebene Anzahl an elektrischen Kontaktstellen 13. Die Lage der Kontaktstellen 13 an der elektrischen Leitung 04 in Umfangsrichtung des Trägers 02 kann während des Herstellungsprozesses variiert werden. Damit ist ein gewählter Abstand in Umfangsrichtung des Trägers 02 zwischen den Elektronikmodulen 05 möglich. Auf diese Weise können die Elektronikmodule 05 entsprechend ihrer Funktion beliebig in den vordefinierten Plätzen positioniert werden.

Die Kontaktstellen 13 der elektrischen Leitung 04 sind über ein elektrisches Verbindungselement 14 mit eingangsseitigen elektrischen Kontaktstellen 15 und ausgangsseitigen elektrischen Kontaktstellen 16 der Elektronikmodule 05 verbunden. Das elektrische Verbindungselement 14 kann beispielsweise als metallische Legierung, als Komposit in einer organischen Matrix oder als Einzelmetall realisiert sein. Der Fachmann wird leicht erkennen, dass die Art der Kontaktierung angepasst werden kann. Beispielsweise können selbstverzahnende, mikrostrukturierte Oberflächen verwendet werden.

Mehrere elektrische Kontaktstellen 15, 16 des Elektronikmoduls 05 befinden sich an mindestens einer Seite des Moduls. Die elektrischen Kontaktstellen 15, 16 der Elektronikmodule 05 sind bevorzugt quaderförmig. In abgewandelten Ausführungen können die Kontaktstellen auch auf der Rückseite der Elektronikmodule angeordnet sein. Eine Kontaktierung kann in diesem Fall bereits durch das Aufsetzen auf den Leiter erfolgen, wenn die Kontaktflächen entsprechend ausgerüstet sind, beispielsweise durch Bonden, Ultraschallschweißen o.ä..

An der Stelle der Unterbrechung 12 der unterbrochenen elektrischen Leiterbahn 08 ist ein Elektronikmodul 05 platziert, welches ein Energieversorgungsmodul ist. Dieses besitzt mindestens zwei elektrische Kontaktstellen 15 und 16 die, wie zuvor beschrieben, durch ein elektrisches Verbindungsmittel 14 mit den Kontaktstellen 13 der unterbrochenen elektrischen Leiterbahn 08 verbunden sind. Dabei ist die eingangsseitige erste Kontaktstelle 15 des Energieversorgungsmoduls mit der Kontaktstelle 13 der elektrischen Leiterbahn 08 vor der Unterbrechung 12 kontaktiert. Und nach der Unterbrechung 12 kontaktiert die ausgangsseitige zweite Kontaktstelle 16 des Energieversorgungsmoduls eine weitere Kontaktstelle 13 der elektrischen Leiterbahn 08.

Die Kontaktstellen der elektrischen Leiterbahn 08 können sich auf einem Kontaktpad befinden, welches durch die Unterbrechung 12 unterbrochen ist. Die Definition eingangs- und ausgangsseitig wird durch die Lage des Systemeingangs beschrieben. Durch das Energieversorgungsmodul 05 wird das eingangsseitig anliegende Eingangspotenzial in ein zu diesem verschiedenes Ausgangspotenzial umgewandelt und an der ausgangsseitigen Kontaktstelle nach der Unterbrechung ausgegeben. Deshalb weisen der Leiterbahnabschnitt vor sowie der Leiterbahnabschnitt nach der Unterbrechung unterschiedliche elektrische Potenziale auf. In diesem Sinne überbrückt das Energieversorgungsmodul die Unterbrechung 12.

Wenngleich die zuvor beschriebene Ausführungsform als Elektronikmodul ein Energieversorgungsmodul verwendet, sei nochmals daran erinnert, dass auch andere Module die an den Leiterbahnen vorgesehenen Unterbrechungen nutzen können, um an einer eingangsseitigen ersten elektrischen Kontaktstelle ein anliegendes Eingangssignal zu empfangen und an einer ausgangsseitigen Kontaktstelle ein zu diesem verschiedenes Ausgangssignal bereit zu stellen.

Werden mehrere Unterbrechungen auf der flexiblen elektrischen Leitung 04 realisiert und durch Energieversorgungsmodule 05 überbrückt, können mehrere unterschiedliche Spannungspotenziale auf der elektrischen Leitung erzeugt werden. Dadurch sind keine zusätzlichen Leiterbahnen für verschiedene Spannungen notwendig. Demzufolge bedarf es prinzipiell nur einer unterbrochenen Versorgungsleitung für mehrere unterschiedliche Versorgungsspannungen die von unterschiedlichen Funktionsmodulen benötigt werden. Dadurch wird nicht nur Material sondern vor allem Platz auf der elektrischen Leitung eingespart.

Derselbe Aufbau ist in abgewandelten Ausführungsformen durch andersartige Elektronikmodule, beispielsweise Schnittstellenwandlermodule oder Schutzbeschaltungsmodule möglich. Es ist auch möglich, eine Potenzialtrennung bei gleichbleibender Spannung vorzunehmen, In einer abgewandelten Ausführungsform kann die Unterbrechung 12 der elektrischen Leiterbahn 08 somit eine Schutzbeschaltung ermöglichen, z.B. als Überspannungsschutz. Dabei liegen vor und nach der Unterbrechung 12 die gleichen Potenziale an, wobei das Potenzial nach der Unterbrechung durch das zwischengeschaltete Elektronikmodul geschützt ist.

Zum Festlegen der Position und der entsprechenden Abstände zwischen den auf dem Träger angeordneten Elektronikmodulen 05 befinden sich Aufnahmen 07 in den Zwischenräumen und bilden die mechanische Schnittstelle. Die Aufnahmen 07 sind fest mit dem Träger 02 verbunden. Da die eingangsseitigen elektrischen Schnittstellen sowohl bei den Energieversorgungsmodulen, als auch bei den Funktionsmodulen gleich ausgeprägt sind, können die Positionen der Elektronikmodule 05 auf dem Träger 02 unter Verwendung der Aufnahmen 07 frei gewählt werden. Daraus ergibt sich der Vorteil vieler unterschiedlicher Bestückungsvarianten.

Durch die erfindungsgemäße Gestaltung der elektrischen Leitung 04 müssen keine Kleinsignale über die Elektronikmodule geführt werden, wodurch Störungen der Kleinsignale durch transiente Ströme, vermieden werden. Auch der Ausfall von einzelnen Elektronikmodulen 05 kann durch die erfindungsgemäße Gestaltung besser ausgeglichen werden.

Die elektrische Leitung 04 kann in abgewandelten Anwendungen eine Verbindung zu Kontakt- bzw. Anschlussklemmen herstellen, wenn darüber eine Kontaktierung mit externen Bauelementen erfolgen soll. Die Kontaktierung der Anschlussleitung zur elektrischen Leitung 04 ist für alle unterschiedlichen Bestückungsvarianten gleich. Der Grund dafür sind die Unterbrechungen 12 der elektrischen Leiterbahn 08 und der damit verbundenen Einsparung weiterer Leiterbahnen, da alle Spannungen mit einer einzigen elektrischen Leiterbahn 08 und den entsprechenden Elektronikmodulen 05 realisiert werden können. Dementsprechend können vorkonfektionierte Kabellösungen eingesetzt werden.

### Bezugszeichenliste

- 01: Lageranordnung
- 02: Träger
- 03: Innenwand des Trägers
- 04: flexible elektrische Leitung
- 05: Elektronikmodul
- 06: -
- 07: Aufnahme
- 08: unterbrochene elektrische Leiterbahn
- 09: Schutzschicht
- 10: adhäsive Schicht 11 -
- 12: Unterbrechung der elektrischen Leiterbahn
- 13: elektrische Kontaktstellen der elektrischen Leitung
- 14: elektrisches Verbindungselement
- 15: eingangsseitige elektrische Kontaktstelle des Elektronikmoduls
- 16: ausgangsseitige elektrische Kontaktstelle des Elektronikmoduls

## Patentansprüche

1. Lageranordnung (01) umfassend:
- ein Lager zur Lagerung eines Maschinenteils;
- mindestens ein Elektronikmodul (05),
- einen Bauraum zur Aufnahme des mindestens einen Elektronikmoduls (05);
- einen sich im Bauraum erstreckenden Träger (02) mit einer elektrischen Leitung (04), die mehrere in Längsrichtung des Trägers verlaufende elektrische Leiterbahnen umfasst;
wobei das mindestens eine Elektronikmodul (05) am Träger befestigt ist und mit einer oder mehreren der Leiterbahnen (08) kontaktiert ist;
**dadurch gekennzeichnet, dass** die elektrische Leitung (04) aus mehreren übereinander gestapelten elektrisch leitenden und elektrisch nicht leitenden Schichten aufgebaut ist und mindestens eine durchgehende elektrische Leiterbahn sowie mindestens eine unterbrochene elektrische Leiterbahn (08) mit mindestens einer Unterbrechung (12) umfasst, wobei die unterbrochene Leiterbahn (08) vor und nach der Unterbrechung (12) parallel zur durchgehenden Leiterbahn verläuft; und dass mindestens ein Elektronikmodul (05) mit einer ersten Kontaktstelle (15) an die unterbrochene Leiterbahn (08) vor der Unterbrechung (12) sowie mit einer zweiten Kontaktstelle (16) an die unterbrochene Leiterbahn (08) nach der Unterbrechung (12) angeschlossen ist; wobei das Elektronikmodul (05) über die erste Kontaktstelle (15) ein Eingangssignal empfängt, dieses in ein Ausgangssignal wandelt und das Ausgangssignal an der zweiten Kontaktstelle (16) ausgibt.

2. Lageranordnung nach Anspruch 1, **dadurch gekennzeichnet, dass** die elektrische Leitung (04) mehrere durchgehende elektrische Leiterbahnen und mehrere unterbrochene Leiterbahnen (08) umfasst.

3. Lageranordnung nach Anspruch 1 oder 2, **dadurch gekennzeichnet, dass** das mindestens eine Elektronikmodul (05) als ein Energieversorgungsmodul, ein Funktionsmodul, ein Schutzbeschaltungsmodul und/oder ein Schnittstellenwandlermodul ausgebildet ist.

4. Lageranordnung nach einem der Ansprüche 1 bis 3, **dadurch gekennzeichnet, dass** die Elektronikmodule (05) mit Aufnahmen (07) am Träger (02) befestigt sind.

5. Lageranordnung nach einem der Ansprüche 1 bis 4, **dadurch gekennzeichnet, dass** alle elektrischen Kontaktstellen (15, 16) des Elektronikmoduls auf einer einzigen Seite des Elektronikmoduls angeordnet sind.

6. Lageranordnung nach einem der Ansprüche 1 bis 5, **dadurch gekennzeichnet, dass** die elektrische Leitung (04) eine flexible Leitung ist und an eine Krümmung des Trägers (02) angepasst werden kann.

7. Lageranordnung nach Anspruch 6, **dadurch gekennzeichnet, dass** die flexible elektrische Leitung (04) an die Elektronikmodulanzahl (05) angepasst ist.

8. Lageranordnung nach einem der Ansprüche 1 bis 7, **dadurch gekennzeichnet, dass** eine Anschlussleitung direkt auf der flexiblen elektrischen Leitung (04) kontaktiert ist.

9. Lageranordnung nach einem der Ansprüche 1 bis 8, **dadurch gekennzeichnet, dass** eine Versorgungsspannung auf einem Abschnitt der unterbrochenen Leiterbahn (08) vor der Unterbrechung (12) durch das Elektronikmodul (05) umgesetzt wird in eine abweichende Versorgungsspannung, die vom Elektronikmodul an einen Abschnitt der unterbrochenen Leiterbahn (08) nach der Unterbrechung (12) eingespeist wird.

10. Lageranordnung nach einem der Ansprüche 1 bis 8, **dadurch gekennzeichnet, dass** eine erstes Signal auf einem Abschnitt der unterbrochenen Leiterbahn (08) vor der Unterbrechung (12) durch das Elektronikmodul (05) umgesetzt wird in eine zweites Signal, welches vom Elektronikmodul an einen Abschnitt der unterbrochenen Leiterbahn (08) nach der Unterbrechung (12) eingespeist wird.

## Claims

1. A bearing assembly (01) comprising:
- a bearing for mounting a machine part;
- at least one electronic module (05),
- an installation space for receiving the at least one electronic module (05);
- a carrier (02) which extends in the installation space and has an electric line (04) comprising a plurality of electric conductor tracks extending in the longitudinal direction of the carrier;
wherein the at least one electronic module (05) is attached to the carrier and is contacted with one or more of the conductor tracks (08);
**characterised in that** the electric line (04) is constructed of a plurality of electrically conductive and electrically non-conductive layers stacked on top of one another and comprises at least one continuous electric conductor track and at least one interrupted electric conductor track (08) having at least one interruption (12), wherein the interrupted conductor track (08) extends before and after the interruption (12) parallel to the continuous conductor track; and that at least one electronic module (05) with a first contact point (15) is connected to the interrupted conductor track (08) before the interruption (12) and with a second contact point (16) to the interrupted conductor track (08) after the interruption (12); wherein the electronic module (05) receives an input signal via the first contact point (15), converts said signal into an output signal and outputs the output signal at the second contact point (16).

2. The bearing assembly according to claim 1, **characterised in that** the electric line (04) comprises a plurality of continuous electric conductor tracks and a plurality of interrupted conductor tracks (08).

3. The bearing assembly according to claim 1 or 2, **characterised in that** the at least one
electronic module (05) is designed as a power supply module, a functional module, a protective circuit module and / or an interface converter module.

4. The bearing assembly according to one of claims 1 to 3, **characterised in that** the electronic modules (05) are secured by means of holders (07) to the carrier (02).

5. The bearing assembly according to one of claims 1 to 4, **characterised in that** all electric contact points (15, 16) of the electronic module are arranged on a single side of the electronic module.

6. The bearing assembly according to one of claims 1 to 5, **characterised in that** the electric line (04) is a flexible line and can be adapted to a curvature of the carrier (02).

7. The bearing assembly according to claim 6, **characterised in that** the flexible electric line (04) is adapted to the number of electronic modules (05).

8. The bearing assembly according to one of claims 1 to 7, **characterised in that** a connecting line is contacted directly on the flexible electric line (04).

9. The bearing assembly according to one of claims 1 to 8, **characterised in that** a supply voltage on a portion of the interrupted conductor track (08) before the interruption (12) is converted by the electronic module (05) into a different supply voltage, which is fed in from the electronic module to a portion of the interrupted conductor track (08) after the interruption (12).

10. The bearing assembly according to one of claims 1 to 8, **characterised in that** a first signal on a portion of the interrupted conductor track (08) before the interruption (12) is converted by the electronic module (05) into a second signal, which is fed in from the electronic module to a portion of the interrupted track (08) after the interruption (12).

## Revendications

1. Ensemble de palier (01) comprenant :
- un palier pour supporter une pièce de machine ;
- au moins un module électronique (05),
- un espace d'installation pour recevoir le au moins un module électronique (05) ;
- un support (02) s'étendant dans l'espace d'installation avec un conducteur électrique (04) qui comprend une pluralité de pistes électroconductrices s'étendant dans la direction longitudinale du support ;
dans lequel le au moins un module électronique (05) est fixé au support et mis en contact avec une ou plusieurs pistes conductrices (08) ;
**caractérisé en ce que** le conducteur électrique (04) est constitué de plusieurs couches électriquement conductrices et non conductrices empilées les unes sur les autres et comprend au moins une piste électroconductrice continue et au moins une piste électroconductrice discontinue (08) comprenant au moins une interruption (12), la piste conductrice discontinue (08) s'étendant avant et après l'interruption (12) parallèlement à la piste conductrice continue ; et **en ce qu'**au moins un module électronique (05) présente un premier point de contact (15) connecté à la piste conductrice discontinue (08) avant l'interruption (12) et un second point de contact (16) connecté à la piste conductrice discontinue (08) après l'interruption (12) ; le module électronique (05) recevant un signal d'entrée via le premier point de contact (15), le convertissant en un signal de sortie et délivrant le signal de sortie au second point de contact (16).

2. Ensemble de palier selon la revendication 1, **caractérisé en ce que** le conducteur électrique (04) comprend une pluralité de pistes électroconductrices continues et une pluralité de pistes conductrices discontinues (08).

3. Ensemble de palier selon la revendication 1 ou 2, **caractérisé en ce que** le au moins un
module électronique (05) est conçu comme un module d'alimentation en énergie, un module fonctionnel, un module de circuit de protection et/ou un module convertisseur d'interface.

4. Ensemble de palier selon l'une quelconque des revendications 1 à 3, **caractérisé en ce que** les modules électroniques (05) sont fixés avec des logements (07) sur le support (02).

5. Ensemble de palier selon l'une quelconque des revendications 1 à 4, **caractérisé en ce que** tous les points de contact électriques (15, 16) du module électronique sont disposés sur un seul côté du module électronique.

6. Ensemble de palier selon l'une quelconque des revendications 1 à 5, **caractérisé en ce que** le conducteur électrique (04) est un conducteur flexible et peut être adapté à une courbure du support (02).

7. Ensemble de palier selon la revendication 6, **caractérisé en ce que** le conducteur électrique flexible (04) est adapté au nombre de module électronique (05).

8. Ensemble de palier selon l'une quelconque des revendications 1 à 7, **caractérisé en ce qu'**une ligne de raccordement est mise en contact directement sur le conducteur électrique flexible (04).

9. Ensemble de palier selon l'une quelconque des revendications 1 à 8, **caractérisé en ce qu'**une tension d'alimentation sur une partie de la piste conductrice discontinue (08) avant l'interruption (12) est convertie par le module électronique (05) en une tension d'alimentation différente qui est alimentée du module électronique à une partie de la piste conductrice discontinue (08) après l'interruption (12).

10. Ensemble de palier selon l'une quelconque des revendications 1 à 8, **caractérisé en ce qu'**un premier signal sur une partie de la piste conductrice discontinue (08) avant l'interruption (12) est converti par le module électronique (05) en un second signal qui est alimenté du module électronique à une partie de la piste conductrice discontinue (08) après l'interruption (12).
